# EUROPÄISCHE PATENTANMELDUNG

(11) **EP 0 763 798 A2**
(43) Veröffentlichungstag der Anmeldung: **19.03.1997**
(21) Anmeldenummer: 96113560.5
(22) Anmeldetag: 23.08.1996
(51) Int. Cl.: G06K 19/077

(54) **Verfahren und Vorrichtung zur Herstellung einer Chipkarte**

(30) Priorität: 25.08.1995 DE 19531542
(71) Anmelder: Ruhlamat Automatisierungstechnik GmbH, 99819 Marksuhl (DE)
(72) Erfinder: Gebhardt, Bernd, 99846 Seebach (DE); Baumann, Holger, 99817 Eisenach (DE); Keppel, Jürgen, 46049 Oberhausen (DE)
(74) Vertreter: Hauck, Hans, Dipl.Ing.

(57) **Zusammenfassung**

Die Erfindung betrifft ein Verfahren zur Herstellung einer Chipkarte mit in einer Eintiefung der Chipkarte eingesetztem und befestigtem Chipmodul. Zur schnellen und schonenden Befestigung des Chipmoduls werden lediglich die auf Abstützflächen der Eintiefung aufliegenden Randbereiche des Chipmoduls mit Hilfe einer aufgesetzten Sonotrode ultraschallverschweißt. Besteht die Unterseite des Chipmoduls nicht aus einem verschweißbaren Thermoplast, so kann die Unterseite des Chipmoduls mit einem Kleber versehen werden, der durch die Ultraschallenergie erwärmt und aktiviert wird, worauf die Befestigung unter Druck erfolgt. Zum Einbringen der Ultraschallenergie weist die Sonotrodenstirnfläche einen vorspringenden Rand auf, der auf das Chipmodul in den Randbereichen aufgesetzt wird.

## Beschreibung

Die Erfindung betrifft ein Verfahren zur Herstellung einer Chipkarte, bei dem aus einem Chipmodulband Chipmodule ausgestanzt werden, die dann in eine Eintiefung einer Chipkarte oberflächenbündig eingesetzt und befestigt werden.

Ein solches Verfahren ist in der Praxis unter der Bezeichnung 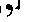 hot-melt-Verfahren" bekanntgeworden, bei dem auf einem Chipmodulband eine Klebefolie auflaminiert ist und die Befestigung in der Eintiefung der Chipkarte durch Aktivieren der Klebefolie mittels Wärme unter Druck erfolgt.

Dabei ist es erforderlich, den Klebstoff unter Zuführung von Wärme zu aktivieren. Die Wärme wird beim hot-melt-Verfahren mittels eines erwärmten Preßstempels zugeführt. Da die Wärme über die Chipkarte zu dem Klebstoff gelangt, erwärmt sich die gesamte Chipkarte relativ stark. Diese Wärme ist für die Funktion des die elektronischen Schaltungen aufweisenden Chipmoduls schädlich und kann außerdem dazu führen, daß sich die Chipkarte verzieht oder auf das ihr vorhandene Druckbild verzerrt und unsauber wird. Deshalb ist es auch bekannt, nach Abheben des erwähnten Preßstempels mit einem gekühlten Stempel Wärme abzuführen. Dies ist u.a. zeitraubend.

Bei Chipkarten, welche aus für UV-Licht durchlässige Folien aufgebaut sind, ist es auch schon bekannt, die Klebeflächen durch kaltes UV-Licht zu aktivieren. Dieses Verfahren hat jedoch nur einen sehr begrenzten Anwendungsbereich, weil sehr häufig die Folien nicht für UV-Licht durchlässig sind.

Der Erfindung liegt die Aufgabe zugrunde, ein Verfahren der eingangs genannten Art so zu gestalten, daß Chipmodule auf Chipkarten schnell und schonend befestigt werden.

Diese Aufgabe wird erfindungsgemäß dadurch gelöst, daß das in Randbereichen auf Abstützflächen der Eintiefung aufliegende Chipmodul allein an diesen Randbereichen durch Zuführen von Ultraschallenergie mittels einer senkrecht zur Kartenebene schwingenden Sonotrode an der Chipkarte befestigt wird.

Aus DE-A-37 27 187 ist es zum Verbinden zweier Strukturen zwar bekannt, einen von einer Schrumpffolie eingeschlossenen, Kabelstränge umgebenden Kleber mittels einer Sonotrode durch Ultraschall zu erwärmen und dadurch zu aktivieren. Dabei kommt es jedoch zwangsläufig zu einem Wärmefluß in die Kabelstränge von allen Seiten her, was bei einem Chipmodul einer Chipkarte zu Funktionsstörungen führen würde.

Durch die erfindungsgemäße Verfahrensweise kommt es ausschließlich in den Bereichen, wo sich die Auflageflächen des Chipmoduls bzw. der Klebstoff befinden, durch Mikroreibung zu einer Umwandlung der Schwingungsenergie in Wärmeenergie. Dadurch entsteht die Wärme genau dort, wo sie gebraucht wird, so daß ein unerwünschtes Erwärmen anderer Bereiche der Chipkarte verhindert werden kann. Trotz dieses gegenüber dem bisherigen Verfahren wesentlichen Vorteils ist das erfindungsgemäße Verfahren sogar kostengünstiger durchzuführen als die bekannten Verfahren und ermöglicht eine extrem kurze Fügezeit.

Das Verfahren setzt voraus, daß die Unterseite des Chipmoduls aus einem Thermoplast besteht und damit ultraschallschweißbar ist. Dies ist nicht regelmäßig der Fall. Dann wird die Unterseite des Chipmoduls mit Klebstoff versehen, sei es eine auflaminierte Klebefolie, ein flüssig aufgebrachter Kleber oder ein aufgedampfer Klebstoff.

Da die Schwingungen der Sonotrode nur am Rand des Chipmoduls eingebracht werden, kommt es nur dort zu einer Erwärmung, wo die Wärme nicht schadet, wodurch Chipbeschädigungen ausgeschlossen und Verformungen der Chipkarte verringert werden. Die Sonotrodenstirnseite ist mit einem vorspringenden Rand versehen, der auf den zu verschweißenden Randbereich des Chipmoduls aufsetzt.

Besonders vorteilhaft ist das Verfahren durchzuführen, wenn gemäß einer anderen Weiterbildung eine Heißklebefolie mit Ausnehmungen verwendet wird, welche sich jeweils über einen mittleren Bereich jedes Chipmoduls erstrecken, so daß nach dem Ausstanzen der Chipmodul mit einem durch die Heißklebefolie gebildeten Klebering versehen ist.

Eine besonders kleine Klebefläche ergibt sich, wenn die Ausnehmung der Chipkarte mehrfach, insbesondere dreifach abgestuft ist. Damit lassen sich die Auflageflächen für das Chipmodul verkleinern und wird ferner Platz geschaffen für die Unterseite des Chipmoduls, die oft herstellerseitig mit einer Vergußmasse versehen ist. Ferner kann in die freien Räume überschüssiger Klebstoff eintreten. Schließlich wird durch die mehrfache Abstufung der Ausnehmung die Fläche der Chipkarte mit der dünnsten Wandstärke verringert, wo die Chipkarte am schwächsten ist. Ferner hat sich gezeigt, daß bei dieser Ausbildung der Ausnehmung die benötigte Ultraschallenergie verkleinert und eine besonders sichere Befestigung ermöglicht wird.

Zur weiteren Verringerung der Klebefläche trägt es bei, ohne daß hierzu die Klebefolie verkleinert werden muß, wenn in den obersten Bereich vom mittleren Bereich aus Einbuchtungen gefräst werden.

Abdrücke auf der Modulkontaktfläche und ein Austritt von verflüssigtem Klebstoff am Chipmodul lassen sich auf einfache Weise dadurch vermeiden, daß zwischen der Chipkarte und der Sonotrode eine Kunststoffschicht, z.B. als Folie vorgesehen wird.

Zur weiteren Verdeutlichung der Erfindung wird nachfolgend auf eine Zeichnung Bezug genommen. Diese zeigt in
- Fig. 1: perspektivische Darstellungen von Bauteilen während verschiedener Verfahrensschritte bei der Chipkartenherstellung,
- Fig. 2: einen Längsschnitt durch eine bei dem Verfahren einzusetzende Sonotrode,
- Fig. 3: eine Draufsicht auf die untere Stirnfläche der Sonotrode, gegenüber Fig. 2 im Maßstab verdoppelt,
- Fig. 4: einen Querschnitt durch eine bei dem erfindungsgemäßen Verfahren verwendete Chipkarte,
- Fig. 5: eine Draufsicht auf einen Teilbereich der Chipkarte,
- Fig. 6: eine Draufsicht auf eine zweite Ausführungsform einer Ausnehmung der Chipkarte.

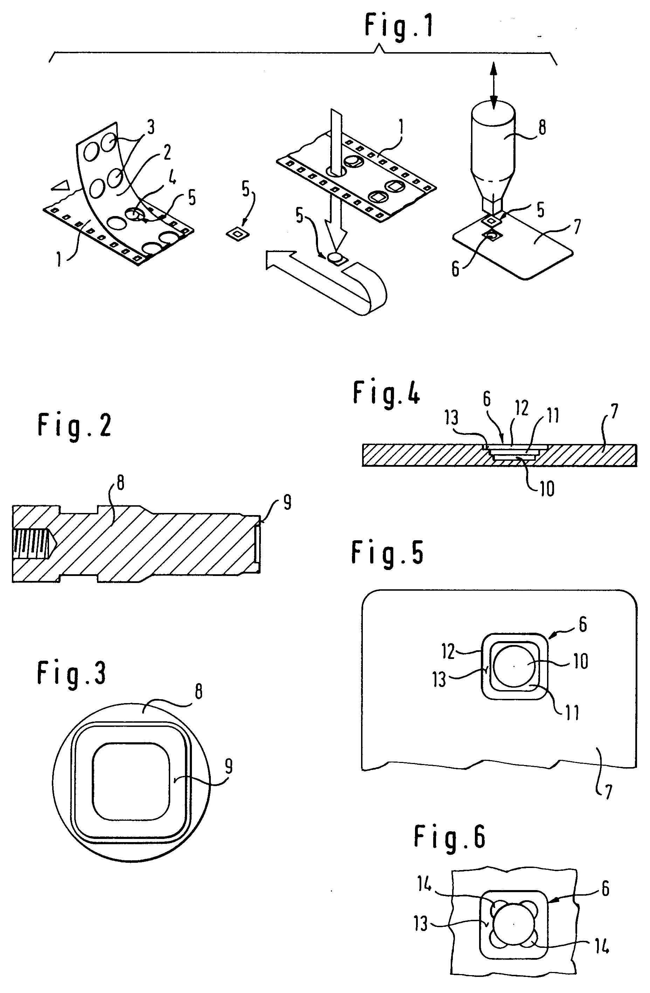

Die Figur 1 zeigt in der linken Darstellung einen Teilbereich eines Chipmodulbandes 1, auf welches eine Klebefolie 2 aufgeklebt wird. Diese hat Ausnehmungen 3, die so bemessen sind, daß jeweils der Chip 4 eines Chipmoduls 5 innerhalb einer Ausnehmung 3 zu liegen kommt.

In der mittleren Darstellung der Figur 1 ist gezeigt, wie ein Chipmodul 5 aus dem Chipmodulband 1 herausgestanzt wurde. Dieses wird anschließend umgedreht. so daß seine Seite mit dem auf ihm verbliebenen, durch die Ausnehmung 3 und den Stanzvorgang aus der Klebefolie 2 gebildeten ringförmigen Kleberand nach unten weist. Anschließend wird dieser Chipmodul 5 in eine Eintiefung 6 einer Chipkarte 7 eingesetzt. Danach setzt man eine Sonotrode 8 auf den Chipmodul 5 und führt mit etwa 40 kHz Ultraschallenergie senkrecht zur Ebene der Chipkarte 7 zu. Dadurch kommt es zu einer Aktivierung des Schmelzklebstoffes der Klebefolie 2 am Chipmodul 5.

In den Figuren 2 und 3 ist die Sonotrode 8 vergrößert dargestellt. Diese hat an ihrer unteren Stirnseite einen umlaufenden, hochgezogenen Rand 9, mit dem sie ausschließlich außenseitig auf dem Chipmodul 5 aufsitzt.

Die Figur 4 zeigt, daß die Eintiefung 6 in der Chipkarte 7 drei im Querschnitt nach oben hin jeweils größere Bereiche 10, 11, 12 hat. Der in der Figur 1 mehrfach gezeigte Chipmodul 5 kommt im oberen Bereich 12 zum Liegen, so daß er ausschließlich mit seinem Rand auf einer Fläche 13 des oberen Bereichs 12 aufliegt und nur dort verklebt wird. Der mittlere Bereich 11 steht zur Aufnahme überschüssigen Klebers zur Verfügung.

In Figur 5 erkennt man die Abstützfläche 13 der Eintiefung 6, auf welcher der Chipmodul 5 im implantierten Zustand aufliegt und dann die Oberseite des Chipmoduls bündig mit der Chipkantenoberfläche ist.

Die Figur 6 zeigt, daß in die Fläche 13 vom Inneren der Eintiefung 6 aus vier Einbuchtungen 14 ragen können, wodurch sich die Fläche 13, auf welcher die Verklebung des Chipmoduls 5 stattfindet, verkleinert.

Anstelle der Klebefolie 2 kann am Rand des Chipmoduls 5 in irgendeiner Form Kleber aufgebracht sein. Besteht die Chipmodulunterseite aus einem schweißbaren Thermoplast, so kann der Kleber weggelassen werden.

## Patentansprüche

1. Verfahren zur Herstellung einer Chipkarte, bei dem aus einem Chipmodulband Chipmodule ausgestanzt werden, die dann in entsprechende Eintiefungen einer Chipkarte oberflächenbündig eingesetzt und darin befestigt werden, dadurch gekennuzeichnet, daß das in Randbereichen auf Abstützflächen der Eintiefung aufliegende Chipmodul allein an diesen Randbereichen durch Zuführen von Ultraschallenergie mittels einer senkrecht zur Kartenebene schwingenden Sonotrode an der Chipkarte befestigt wird.

2. Verfahren nach Anspruch 1, dadurch gekennzeichnet, daß die Randbereiche des Chipmoduls mit Klebstoff versehen werden, der mittels der Ultraschallenergie erwärmt und zum Verkleben unter Druck aktiviert wird.

3. Verfahren nach Anspruch 2, dadurch gekennzeichnet, daß der Klebstoff in Form einer Klebefolie zugeführt wird.

4. Verfahren nach Anspurch 3, dadurch gekennzeichnet, daß die Klebefolie mit Ausnehmungen versehen wird, welche sich jeweils über einen mittleren Bereich jedes Chipmoduls erstrecken, so daß nach dem Ausstanzen der Chipmodul mit einem durch die Klebefolie gebildeten Klebering versehen ist.

5. Verfahren nach einem der Ansprüche 1 bis 4, dadurch gekennzeichnet, daß zwischen der Chipkarte und der Sonotrode eine Kunststoffschicht gelegt wird.

6. Mit dem Verfahren nach einem der Ansprüche 1 bis 5 hergestellte Chipkarte, dadurch gekennzeichnet, daß die Eintiefung (6) in der Chipkarte (7) mehrfach abgestuft ist, wobei der oberste Bereich (12) mit seiner Abstützfläche (13) zur Auflage des Chipmoduls dient und die unteren Bereiche (10, 11) zur Aufnahme der Unterseite des Chipmoduls und für überflüssigen Klebstoff dienen.

7. Chipkarte nach Anspruch 6, dadurch gekennzeichnet, daß in den obersten Bereich (12) vom mittleren Bereich (11) aus Einbuchtungen (14) gefräst sind.

8. Vorrichtung zum Durchführen des Verfahrens nach einem der Ansprüche 1 bis 7, dadurch gekennzeichnet, daß die Sonotrodenstirnfläche mit einem umlaufenden, vorspringen Rand (9) versehen ist, mit dem sie ausschließlich auf den Randbereichen des Chipmoduls (5) aufsitzt.
